# EUROPÄISCHE PATENTANMELDUNG

(11) **EP 4 435 155 A1**
(43) Veröffentlichungstag der Anmeldung: **25.09.2024**
(21) Anmeldenummer: 23163761.2
(22) Anmeldetag: 23.03.2023
(51) Int. Cl.: C30B 29/36, C30B 33/02

(54) **VERFAHREN UND VORRICHTUNG ZUR THERMISCHEN NACHBEHANDLUNG MINDESTENS EINES SIC-VOLUMENKRISTALLS**

(71) Anmelder: SiCrystal GmbH, 90411 Nürnberg (DE)
(72) Erfinder: Ecker, Bernhard, 90411 Nürnberg (DE); Kowasch, Maximilian, 90411 Nürnberg (DE); Müller, Ralf, 90411 Nürnberg (DE); Schuh, Philipp, 90411 Nürnberg (DE); Stockmeier, Matthias, 90411 Nürnberg (DE); Takegawa, Daisuke, 90411 Nürnberg (DE); Vogel, Michael, 90411 Nürnberg (DE); Weber, Arnd-Dietrich, 90411 Nürnberg (DE)
(74) Vertreter: Rau, Schneck & Hübner Patentanwälte Rechtsanwälte PartGmbB

(57) **Zusammenfassung**

Das Verfahren ist zur thermischen Nachbehandlung mindestens eines SiC-Volumeneinkristalls (2) bestimmt, der eine im Wesentlichen zylindrische Grundform mit einer in einer axialen Richtung gemessenen Kristalllänge, mit einem in einer radialen Richtung gemessenen Kristalldurchmesser, mit einer in der axialen Richtung verlaufenden Kristallmittenlängsachse (10) sowie mit drei Begrenzungsflächen, nämlich einer Bodenfläche (11), einer Deckfläche (12) und einer Umfangsrandfläche (13), aufweist. Der SiC-Volumeneinkristall (2) wird zur Reduzierung von im SiC-Volumeneinkristall (2) nach Abschluss der vorausgegangenen Züchtung vorhandener mechanischer Spannungen auf eine Nachbehandlungstemperatur gebracht, wobei im SiC-Volumeneinkristall (2) ein inhomogener Temperaturverlauf mit einem radialen thermischen Gradienten, der ausgehend von der Kristallmittenlängsachse (10) zur Umfangsrandfläche (13) kontinuierlich ansteigt, eingestellt wird, und ein Wärmeaustausch des SiC-Volumeneinkristalls (2) mit einem ihn umgebenden freien Raum (4) mittels freier Wärmestrahlung an mindestens zwei der drei Begrenzungsflächen (11, 12, 13) stattfindet.

## Beschreibung

Die Erfindung betrifft ein Verfahren zur thermischen Nachbehandlung mindestens eines SiC-Volumeneinkristalls, der eine im Wesentlichen zylindrische Grundform mit einer in einer axialen Richtung gemessenen Kristalllänge, mit einem in einer radialen Richtung gemessenen Kristalldurchmesser, mit einer in der axialen Richtung verlaufenden Kristallmittenlängsachse sowie mit drei Begrenzungsflächen, nämlich einer Bodenfläche, einer Deckfläche und einer Umfangsrandfläche, aufweist. Außerdem betrifft die Erfindung eine Vorrichtung zur thermischen Nachbehandlung mindestens eines solchen SiC-Volumeneinkristalls.

Das Halbleitermaterial Siliziumcarbid (SiC) wird aufgrund seiner herausragenden physikalischen, chemischen, elektrischen und optischen Eigenschaften unter anderem auch als Ausgangsmaterial für leistungselektronische Halbleiterbauelemente, für Hochfrequenzbauelemente und für spezielle lichtgebende Halbleiterbauelemente eingesetzt. Für diese Bauelemente werden SiC-Substrate (= SiC-Wafer) mit möglichst großem Substratdurchmesser und möglichst hoher Qualität benötigt. Basis hierfür sind hochwertige SiC-Volumeneinkristalle.

Solche SiC-Volumeneinkristalle werden in der Regel mittels physikalischer Gasphasenabscheidung (PVT), z.B. mittels eines in der US 8,865,324 B2 beschriebenen Sublimationsverfahrens, hergestellt. Dabei wird eine einkristalline SiC-Scheibe als SiC-Keimkristall zusammen mit geeignetem Quellmaterial in einen Züchtungstiegel eingebracht. Unter kontrollierten Temperatur-, Druck- und Gasbedingungen wird das Quellmaterial sublimiert und die gasförmigen Spezies (= SiC-Wachstumsgasphase) scheiden sich auf dem SiC-Keimkristall ab, wodurch der SiC-Volumeneinkristall aufwächst.

Aus diesen SiC-Volumeneinkristallen werden die scheibenförmigen einkristallinen SiC-Substrate herausgeschnitten, die dann nach einer insbesondere mehrstufigen Polierbehandlung ihrer Oberflächen im Rahmen der Bauelementefertigung mit mindestens einer insbesondere auch aus SiC bestehenden Epitaxieschicht versehen werden. In der Regel werden Defekte aus dem SiC-Substrat in die aufgebrachte Epitaxieschicht vererbt und führen damit zu einer Verschlechterung der Bauelementeeigenschaften. Die Qualität der Bauelemente hängt also wesentlich von der des gezüchteten SiC-Volumeneinkristalls und der daraus gewonnenen SiC-Substrate ab.

Für die Herstellung der epitaktischen Schichten der Bauelemente ist die Geometrie des verwendeten SiC-Substrats von großer Bedeutung. So erreicht man in einem Epitaxie-Reaktor eine gute thermische Ankopplung, welche für homogenes und qualitativ hochwertiges epitaktisches Schichtwachstum sehr wichtig ist, im Wesentlichen nur bei SiC-Substraten, die keine nennenswerte Verbiegung aufweisen. Dagegen führen SiC-Substrate mit schlechten Geometrieeigenschaften, also insbesondere mit zu großer Verbiegung (engl.: bow) und/oder Wölbung (engl.: warp), zwangsläufig zu geringerer Qualität bzw. geringerer Ausbeute des Epitaxie-Prozesses.

In der DE 10 2009 048 868 B4 wird ein Verfahren zur thermischen Nachbehandlung eines SiC-Volumeneinkristalls beschrieben, um thermische Spannungen innerhalb des SiC-Volumeneinkristalls zu reduzieren und somit die Kristallqualität zu verbessern. Der SiC-Volumeneinkristall wird nach seiner Züchtung während eines zusätzlichen Prozessschrittes in einem Tiegel getempert, wobei er vollständig in SiC-Pulver eingebettet ist. Während der thermischen Nachbehandlung liegt im SiC-Volumeneinkristall ein möglichst isothermes bzw. homogenes Temperaturfeld vor. Vorzugsweise wird ein in Richtung der Mittenlängsachse gemessener (= axialer) möglichst niedriger Temperaturunterschied von höchstens 2 K eingestellt, um einen Ausgleich mechanischer Spannungen in axialer Richtung zu begünstigen. Mit einem solchen isothermen Temperaturfeld lässt sich allerdings nur global auf Stressfelder im SiC-Volumeneinkristall einwirken, so dass die in der Kristallstruktur vorhandenen mechanischen Spannungen nur zum Teil abgebaut werden.

In der US 8,449,671 B2 wird ein weiteres Verfahren zur thermischen Nachbehandlung eines SiC-Volumeneinkristalls beschrieben, das die Geometrie der aus ihm gewonnenen SiC-Substrate positiv beeinflussen soll. Während dieser Nachbehandlung wird der SiC-Volumeneinkristall mit einem axialen Temperaturgradienten beaufschlagt, der gegensinnig zu dem während der Kristallzüchtung eingestellten axialen Temperaturgradienten ist. Dabei kann der zu tempernde SiC-Volumeneinkristall auf einem Zwischenstück aus Graphit aufliegen.

In US 7,767,022 B1 wird ein weiteres Verfahren zur thermischen Nachbehandlung eines SiC-Volumeneinkristalls beschrieben, bei dem er entweder direkt oder indirekt vollständig in einem pulverförmigen polykristallinen SiC-Quellmaterial eingebettet ist. Bei der indirekten Einbettung befindet sich der zu tempernde SiC-Volumeneinkristall in einem dünnwandigen Behälter aus porösem Graphit von geringer Dichte, der dann seinerseits innerhalb des polykristallinen SiC-Quellmaterials platziert ist. Die Temperung soll bei möglichst einheitlicher Temperatur stattfinden. Vorzugsweise sind sowohl axiale als auch radiale Temperaturgradienten minimiert.

Die Aufgabe der Erfindung besteht deshalb darin, ein weiter verbessertes Verfahren sowie eine weiter verbesserte Vorrichtung zur thermischen Nachbehandlung eines SiC-Volumeneinkristalls anzugeben.

Zur Lösung der das Verfahren betreffenden Aufgabe wird ein Verfahren entsprechend den Merkmalen des Anspruchs 1 angegeben. Bei dem erfindungsgemäßen Verfahren wird der SiC-Volumeneinkristall zur Reduzierung von im SiC-Volumeneinkristall nach Abschluss der vorausgegangenen Züchtung vorhandener mechanischer Spannungen auf eine Nachbehandlungstemperatur gebracht, wobei im SiC-Volumeneinkristall ein inhomogener Temperaturverlauf mit einem radialen thermischen Gradienten, der ausgehend von der Kristallmittenlängsachse zur Umfangsrandfläche kontinuierlich ansteigt, eingestellt wird, und ein Wärmeaustausch des SiC-Volumeneinkristalls mit einem ihn umgebenden freien Raum mittels freier Wärmestrahlung an mindestens zwei der drei Begrenzungsflächen stattfindet.

Die Bodenfläche des SiC-Volumeneinkristalls ist insbesondere im Wesentlichen kreisförmig und vorzugsweise im Wesentlichen eben. Bevorzugt, aber nicht zwingend, ist die Bodenfläche durch die Unterseite des zur Züchtung des SiC-Volumeneinkristalls verwendeten SiC-Keimkristalls gebildet. Alternativ kann der SiC-Keimkristall aber auch vor der thermischen Nachbehandlung vom während der vorangegangenen Züchtung aufgewachsenen Teil des SiC-Volumeneinkristalls abgetrennt werden. Die Deckfläche des SiC-Volumeneinkristalls liegt der Bodenfläche gegenüber. Sie ist insbesondere uneben, vorzugsweise kappen- oder kuppelförmig. Die Umfangsrandfläche hat insbesondere im Wesentlichen die Form einer zylindrischen Mantelfläche. Während seiner Züchtung ist der SiC-Volumeneinkristall in axialer Richtung aufgewachsen. Mit "axial" ist hier also eine Richtung parallel zur oder längs der zentralen Kristallmittenlängsachse, mit "radial" eine dazu senkrechte Richtung und mit "tangential" eine um die Kristallmittenlängsachse umlaufende Umfangsrichtung bezeichnet.

Es wurde erkannt, dass der radiale thermische Gradient, der während der thermischen Nachbehandlung im zu tempernden SiC-Volumeneinkristall herrscht, für den Abbau mechanischer Spannungen in der Kristallstruktur eine größere Bedeutung hat als der bislang bei bekannten Nachbehandlungsverfahren im Vordergrund stehende axiale thermische Gradient. Dies gilt insbesondere, je größer der Kristalldurchmesser ist.

Während der Sublimationszüchtung des SiC-Volumeneinkristalls wird die Wachstumsgrenzfläche durch isotherme Linien des Temperaturfeldes vorgegeben. Eine gekrümmte Wachstumsgrenzfläche ist eine wichtige Voraussetzung, um qualitativ hochwertige SiC-Volumeneinkristalle herzustellen. Der SiC-Volumeneinkristall wächst während der Züchtung deshalb in einem gekrümmten Temperaturfeld auf. An der gekrümmten Wachstumsgrenzfläche herrschen unterschiedliche Temperaturen. Dies gilt insbesondere für einen Temperaturvergleich zwischen dem Zentrum und dem Randbereich der Wachstumsgrenzfläche. Durch diese Temperaturunterschiede werden im aufwachsenden SiC-Volumeneinkristall Versetzungen und mechanische Spannungen generiert. Auch ein später aus dem SiC-Volumeneinkristall herausgeschnittenen SiC-Substrat hat Teilbereiche, die während der Kristallzüchtung bei unterschiedlichen Temperaturen aufgewachsen sind. Die dadurch in dem SiC-Substrat hervorgerufenen mechanischen Spannungen sind eine Ursache für die bereits angesprochenen störenden Verbiegungen (engl.: bow) und/oder Wölbungen (engl.: warp) . Die Krümmung der während der Züchtung eingestellten thermischen Felder verläuft auch zu einem maßgeblichen Teil in radialer Richtung.

Hier setzt die vorliegende Erfindung an. Es wurde nämlich herausgefunden, dass ein ausgehend von der Kristallmittenlängsachse in radialer Richtung kontinuierlich ansteigender thermischer Gradient eine besonders wirksame thermische Nachbehandlungsmaßnahme ist, um den gewünschten Spannungsabbau im SiC-Volumeneinkristall und den daraus resultierenden positiven Einfluss auf die Geometrie der aus dem SiC-Volumeneinkristall gewonnenen SiC-Substrate zu erzielen. Ein solcher kontinuierlich ansteigender radialer thermischer Gradient führt vorteilhafterweise zu einer Reduzierung oder bevorzugt sogar zu einer Minimierung des Spannungshaushaltes in der Kristallstruktur des SiC-Volumeneinkristalls. Unter Spannungen sind hierbei insbesondere eingefrorene Versetzungen und/oder andere Fehler im Kristallgitter zu verstehen. Während der thermischen Nachbehandlung wird der SiC-Volumeneinkristall auf eine Nachbehandlungstemperatur gebracht, bei der diese Versetzungen vorzugsweise mobilisiert werden. Sie können sich dann innerhalb der Kristallstruktur bewegen. Durch einen in radialer Richtung kontinuierlich ansteigenden Temperaturgradienten wird auch eine Richtung vorgegeben, in welche sich die mobilisierten Versetzungen bevorzugt bewegen. Die Versetzungen bewegen sich dann insbesondere radial nach außen oder lösen sich auf. Dadurch wird vorteilhafterweise auch die Entropie im SiC-Volumeneinkristall reduziert.

Es wurde weiterhin erkannt, dass sich dieser vorteilhafte inhomogene Temperaturverlauf mit in radialer Richtung kontinuierlich ansteigendem thermischen Gradienten besonders gut einstellen lässt, indem der SiC-Volumeneinkristall während der thermischen Nachbehandlung insbesondere an mehr als 50 % seiner gesamten Kristalloberfläche von freiem Raum umgeben ist bzw. mit diesen mehr als 50 % seiner gesamten Kristalloberfläche an freien Raum angrenzt. Der SiC-Volumeneinkristall ist an diesen Stellen insbesondere kontaktfrei, hat also keinen mechanischen Kontakt zu anderen Gegenständen, wie z.B. zu einer Innenwand des Nachbehandlungstiegels oder zu einer Haltefläche der Kristallhalterung, oder zu anderen Materialien, wie z. B. zu SiC-Pulvermaterial. Vorteilhafterweise erfolgt dann der Wärmeaustausch zwischen dem zu tempernden SiC-Volumeneinkristall und dem freien Raum an diesen kontaktfreien Stellen, die sich an mindestens zwei der drei Begrenzungsflächen des SiC-Volumeneinkristalls befinden, mittels freier Wärmestrahlung. Insbesondere erfolgt der Wärmeaustausch an den nicht kontaktfreien, also an den kontaktierten Stellen oder Bereichen des SiC-Volumeneinkristalls dagegen hauptsächlich mittels Wärmeleitung, wobei der Anteil an der gesamten Kristalloberfläche mit freier Wärmestrahlung gegenüber dem Anteil an der gesamten Kristalloberfläche mit Wärmeleitung vorzugsweise dominiert. Beide Mechanismen übertragen bei der Nachbehandlungstemperatur Wärme unterschiedlich gut, der Wärmestrahlungsmechanismus insbesondere besser als der Wärmeleitungsmechanismus. Das Verhältnis des Flächenanteils mit Wärmeleitung zu dem Flächenanteil mit freier Wärmestrahlung ist insbesondere ein bevorzugter Parameter zur Einstellung des inhomogenen Temperaturverlaufs mit in radialer Richtung kontinuierlich ansteigendem thermischen Gradienten.

Im Gegensatz dazu wird bei einigen der bislang bekannten thermischen Nachbehandlungsverfahren gerade ein gegenteilig ausgestaltetes Temperaturfeld eingestellt. Dies gilt insbesondere für Nachbehandlungsverfahren, bei denen der SiC-Volumeneinkristall komplett mit SiC-Pulver umgeben wird. Diese Einbettung erfolgt insbesondere, um eine bei hohen Nachbehandlungs-Temperaturen möglicherweise auftretende nichtstöchiometrische Auflösung des SiC-Volumeneinkristalls zu verhindern. Andererseits vermindert die vollständige Einbettung in SiC-Pulver einen Wärmetransport durch Wärmestrahlung. Stattdessen erfolgt der Wärmeaustausch mit der Umgebung fast ausschließlich mittels Wärmeleitung. Somit stellt sich bei diesen Nachbehandlungsverfahren eine hohe Temperaturhomogenität im zu tempernden SiC-Volumeneinkristall ein. Deshalb kann aber kein ähnlich vorteilhafter Spannungsabbau im SiC-Volumeneinkristall erreicht werden wie bei dem erfindungsgemäßen Nachbehandlungsverfahren aufgrund des inhomogenen Temperaturverlaufs mit kontinuierlich ansteigendem radialen thermischen Gradienten. Darüber hinaus hat das erfindungsgemäße Verfahren einen weiteren Vorteil gegenüber dem bekannten Nachbehandlungsverfahren mit der Einbettung des SiC-Volumeneinkristalls in SiC-Pulver. Ohne derartige Einbettung kann es zwar zu einem Abdampfen von SiC von der Oberfläche des SiC-Volumeneinkristalls kommen. Diesem Effekt kann aber durch eine Anpassung, insbesondere eine Erhöhung des Prozessdrucks im Nachbehandlungstiegel entgegengewirkt werden. Andererseits bietet ein Verzicht auf die Einbettung in SiC-Pulver den Vorteil, dass während der erfindungsgemäßen thermischen Nachbehandlung kein parasitäres SiC unkontrolliert an den zu tempernden SiC-Volumeneinkristall anwächst. Derartige Anwachsungen von parasitärem SiC können beim Abkühlen eines in SiC-Pulver eingebetteten SiC-Volumeneinkristalls nach Abschluss der thermischen Nachbehandlung erneute und/oder zusätzliche mechanische Spannungen im Randbereich des SiC-Volumeneinkristalls hervorrufen, die sich insbesondere aufgrund der durch sie verursachten Verbiegungen und/oder Wölbungen negativ auf die Geometrie der aus dem SiC-Volumeneinkristall hergestellten SiC-Substrate auswirken können

Vorteilhafte Ausgestaltungen des erfindungsgemäßen Verfahrens ergeben sich unter anderem aus den Merkmalen der von Anspruch 1 abhängigen Ansprüche.

Günstig ist eine Ausgestaltung, bei der der Wärmeaustausch des SiC-Volumeneinkristalls mit dem ihn umgebenden freien Raum mittels freier Wärmestrahlung an allen drei Begrenzungsflächen stattfindet. Insbesondere können sich kontaktfreie Stellen oder Bereiche des SiC-Volumeneinkristalls an allen drei seiner Begrenzungsflächen befinden, wobei die jeweilige Begrenzungsfläche vorzugsweise vollständig oder auch nur teilweise kontaktfrei sein kann. Der Wärmeaustausch mittels Wärmestrahlung ist dann besonders effizient. An den nicht kontaktfreien, also an den kontaktierten Stellen oder Bereichen des SiC-Volumeneinkristalls erfolgt der Wärmeaustausch dagegen hauptsächlich mittels Wärmeleitung.

Gemäß einer weiteren günstigen Ausgestaltung findet der Wärmeaustausch des SiC-Volumeneinkristalls mit dem ihn umgebenden freien Raum mittels freier Wärmestrahlung an einem Strahlungsflächenanteil einer Gesamtoberfläche des SiC-Volumeneinkristalls statt, wobei sich die Gesamtoberfläche aus der Summe der drei Begrenzungsflächen zusammensetzt und der Strahlungsflächenanteil im Bereich von 63 % bis 83 %, insbesondere von 63 % bis 78% der Gesamtoberfläche liegt. Dadurch lässt sich der inhomogene Temperaturverlauf mit dem ausgehend von der Kristallmittenlängsachse radial kontinuierlich ansteigen thermischen Gradienten besonders gut einstellen. Der Strahlungsflächenanteil ist insbesondere der Anteil der Gesamtoberfläche, der keinen Kontakt zu anderen Gegenständen oder Materialien hat. Er ist also vorzugsweise kontaktfrei.

Gemäß einer weiteren günstigen Ausgestaltung wird der radiale thermische Gradient so eingestellt, dass er in einem zentralen Bereich des SiC-Volumeneinkristalls, der sich in radialer Richtung von der Kristallmittenlängsachse bis zu dem halben Kristalldurchmesser erstreckt, Werte zwischen 0,1 K/cm und 0,3 K/cm, insbesondere zwischen 0,1 K/cm und 0,25 K/cm annimmt. Dadurch erfolgt ein besonders guter Spannungsabbau in der Kristallstruktur des SiC-Volumeneinkristalls.

Gemäß einer weiteren günstigen Ausgestaltung wird der radiale thermische Gradient so eingestellt, dass er in einem Randbereich des SiC-Volumeneinkristalls, der sich in radialer Richtung von dem halben Kristalldurchmesser bis zur Umfangsrandfläche erstreckt, Werte zwischen 0,25 K/cm und 0,8 K/cm, insbesondere zwischen 0,25 K/cm und 0,7 K/cm annimmt. Auch diese Maßnahme begünstigt den Spannungsabbau in der Kristallstruktur des SiC-Volumeneinkristalls.

Gemäß einer weiteren günstigen Ausgestaltung wird für die Nachbehandlungstemperatur ein Temperaturwert eingestellt, der höher, insbesondere um bis zu 500 °C höher, vorzugsweise um bis zu 200 °C höher als eine Züchtungstemperatur ist, bei der der SiC-Volumeneinkristall vorher gezüchtet worden ist. Insbesondere wird eine Nachbehandlungstemperatur von größer als 1950 °C, bevorzugt von größer als 2000 °C, vorzugsweise von größer als 2200 °C eingestellt, wobei ein oberer Grenzwert dieser Temperatur insbesondere bei 2500 °C, bevorzugt bei 2450 °C liegt.

Gemäß einer weiteren günstigen Ausgestaltung wird um den SiC-Volumeneinkristall eine Gasatmosphäre eingestellt, wozu mindestens ein siliziumfreies Prozessgas zugeführt wird. Vorzugsweise wird als das mindestens eine siliziumfreie Prozessgas ein Gas aus der Gruppe von Argon, Helium, einem anderen Edelgas und Stickstoff oder ein Gasgemisch aus dieser Gruppe zugeführt. Die thermische Nachbehandlung des SiC-Volumeneinkristalls erfolgt insbesondere ohne aktive Zuführung von Silizium-haltigen Komponenten, wie z.B. Gasen oder Feststoffen. Es werden insbesondere keine Silizium-haltigen Komponenten, Gase oder Feststoffe, wie z.B. SiC-Pulver, in den Nachbehandlungstiegel eingebracht. Der zu tempernde SiC-Volumeneinkristall kommt vorzugsweise nicht in direkten Kontakt mit solchen Silizium-haltigen Komponenten. Auch ein indirekter Kontakt, wie er beispielsweise durch Zwischenschaltung einer Barriere z.B. in Form eines eingesetzten porösen Trennelementes oder einer porösen Membran zustande kommen könnte, ist hier insbesondere nicht vorhanden. Dadurch wird die Bildung einer Silizium-haltigen Atmosphäre im Nachbehandlungstiegel aufgrund der aktiven Zuführung von Silizium-haltigen Komponenten vermieden. Insbesondere stammen etwaige trotzdem in der Atmosphäre in geringer Menge vorhandene Silizium-haltige Gasanteile im Wesentlichen nur aus dem zu tempernden SiC-Volumeneinkristall selbst, beispielsweise aufgrund von Abdampfen von SiC von der Oberfläche des SiC-Volumeneinkristalls.

Gemäß einer weiteren günstigen Ausgestaltung wird ein Prozessgasdruck im Bereich zwischen 800 mbar und 1200 mbar, insbesondere im Bereich zwischen 800 mbar und 1000 mbar eingestellt.

Gemäß einer weiteren günstigen Ausgestaltung beträgt die Kristalllänge höchstens 50 mm, insbesondere höchstens 45 mm. Vorzugsweise liegt sie zwischen 25 mm und 30 mm. Ein unterer Grenzwert für die Kristalllänge liegt insbesondere bei 15 mm, bevorzugt bei 25 mm und höchst bevorzugt bei 30 mm.

Gemäß einer weiteren günstigen Ausgestaltung beträgt der Kristalldurchmesser mindestens 150 mm, insbesondere mindestens 200 mm. Ein oberer Grenzwert für den Kristalldurchmesser liegt insbesondere bei 450 mm, bevorzugt bei 300 mm. Mit zunehmenden Kristalldurchmesser steigt die Wahrscheinlichkeit, dass aus dem SiC-Volumeneinkristall hergestellte SiC-Substrate störende Verbiegungen und/oder Wölbungen aufweisen, die durch thermisch bedingte mechanische Spannungen in der Kristallstruktur des SiC-Volumeneinkristalls induziert sind. Insbesondere trifft dies auf SiC-Volumeneinkristalle mit einem Kristalldurchmesser von etwa 150 mm und größer zu. Deshalb ist das erfindungsgemäße Nachbehandlungsverfahren bei einem SiC-Volumeneinkristall mit so großem Kristalldurchmesser besonders vorteilhaft und effizient, da die dann vermehrt in der Kristallstruktur des SiC-Volumeneinkristalls vorhandenen mechanischen Spannungen abgebaut werden.

Gemäß einer weiteren günstigen Ausgestaltung liegt ein Aspektverhältnis, das mittels Division der Kristalllänge durch den Kristalldurchmesser gebildet ist, im Bereich zwischen 0,05 und 0,35, insbesondere im Bereich zwischen 0,1 und 0,3. Die Kristalllänge der SiC-Volumeneinkristalle, die mittels physikalischer Gasphasenabscheidung (PVT) hergestellt werden können, ist insbesondere auf einige wenige Zentimeter begrenzt und weitgehend unabhängig vom Kristalldurchmesser. Mit steigendem Kristalldurchmesser verändert sich somit das Aspektverhältnis der SiC-Volumeneinkristalle. Es wird immer kleiner. Der radiale thermische Gradient dominiert gegenüber dem axialen thermischen Gradienten mit steigendem Kristalldurchmesser zunehmend die Eigenschaften des wachsenden SiC-Volumeneinkristalls. Folglich werden auch die Spannungen im wachsenden SiC-Volumeneinkristall sowie der Einfluss auf die Geometrie der später daraus hergestellten SiC-Substrate immer stärker durch den während der Züchtung herrschenden radialen thermischen Gradienten bestimmt. Es wurde erkannt, dass der axiale thermische Gradient bei Unterschreiten einer gewissen Obergrenze des Aspektverhältnisses von untergeordneter Bedeutung ist, was sowohl für die Züchtung als auch für die thermische Nachbehandlung des SiC-Volumeneinkristalls gilt. Diese Obergrenze des Aspektverhältnisses liegt insbesondere im Bereich zwischen 0,3 und 0,35. Ausschlaggebend ist stattdessen dann die bei dem erfindungsgemäßen Nachbehandlungsverfahren vorgesehene Fokussierung auf den radialen thermischen Gradienten, um den gewünschten positiven Einfluss auf die Geometrie der aus dem zu tempernden SiC-Volumeneinkristall hergestellten SiC-Substrate zu erzielen.

Gemäß einer weiteren günstigen Ausgestaltung wird der thermisch nachzubehandelnde mindestens eine SiC-Volumeneinkristall auf einer in einem Nachbehandlungstiegel angeordneten Kristallhalterung mit einer Haltefläche zur Kontaktierung und Halterung des mindestens einen SiC-Volumeneinkristalls platziert, wobei die Haltefläche den nachzubehandelnden mindestens einen SiC-Volumeneinkristall nur in einem radialen Randbereich des SiC-Volumeneinkristalls kontaktiert.

Gemäß einer weiteren günstigen Ausgestaltung wird ein Innendurchmesser des Nachbehandlungstiegels vorgesehen, der größer ist als der Kristalldurchmesser, so dass bei in dem Nachbehandlungstiegel eingesetztem SiC-Volumeneinkristall zwischen der Umfangsrandfläche des SiC-Volumeneinkristalls und einer Innenwand des Nachbehandlungstiegels ein tangential vollständig umlaufender freier Ringspalt vorhanden ist.

Gemäß einer weiteren günstigen Ausgestaltung wird für die Kristallhalterung eine Ausbildung als ringförmige Kristallauflage vorgesehen.

Gemäß einer weiteren günstigen Ausgestaltung wird für die Kristallauflage eine in axialer Richtung gemessene Dicke im Bereich zwischen 1 mm und 5 mm, insbesondere im Bereich zwischen 1 mm und 3 mm vorgesehen. Gemäß einer weiteren günstigen Ausgestaltung wird für ein Halterungsmaterial, aus dem die Kristallhalterung besteht oder das sie enthält, eine geringere thermische Leitfähigkeit als diejenige eines Tiegelmaterials, aus dem der Nachbehandlungstiegel besteht oder das er enthält, vorgesehen.

Gemäß einer weiteren günstigen Ausgestaltung wird für ein Halterungsmaterial, aus dem die Kristallhalterung besteht oder das sie enthält, eine höhere Porosität als diejenige eines Tiegelmaterials, aus dem der Nachbehandlungstiegel besteht oder das er enthält, vorgesehen.

Zur Lösung der die Vorrichtung betreffenden Aufgabe wird eine Vorrichtung entsprechend den Merkmalen des Anspruchs 10 angegeben. Die erfindungsgemäße Vorrichtung hat einen thermischen Nachbehandlungstiegel mit einem Aufnahmeraum für den thermisch nachzubehandelnden mindestens einen SiC-Volumeneinkristall, eine Heizeinrichtung zur Erhitzung des Nachbehandlungstiegels sowie des darin zur Reduzierung von im SiC-Volumeneinkristall nach Abschluss der vorausgegangenen Züchtung vorhandener mechanischer Spannungen zu platzierenden SiC-Volumeneinkristalls auf eine Nachbehandlungstemperatur und eine im Nachbehandlungstiegel angeordnete Kristallhalterung mit einer Haltefläche zur Kontaktierung und Halterung des thermisch nachzubehandelnden mindestens einen SiC-Volumeneinkristalls. Dabei kontaktiert die Haltefläche den nachzubehandelnden mindestens einen SiC-Volumeneinkristall nur in einem radialen Randbereich des SiC-Volumeneinkristalls, so dass sich im nachzubehandelnden mindestens einen SiC-Volumeneinkristall ein inhomogener Temperaturverlauf mit einem radialen thermischen Gradienten, der ausgehend von der Kristallmittenlängsachse zur Umfangsrandfläche kontinuierlich ansteigt, einstellt, und ein Wärmeaustausch des nachzubehandelnden mindestens einen SiC-Volumeneinkristalls mit einem ihn umgebenden freien Raum mittels freier Wärmestrahlung an mindestens zwei der drei Begrenzungsflächen stattfindet, wobei der freie Raum ein Bestandteil des Aufnahmeraums ist.

Der von der Haltefläche der Kristallhalterung kontaktierte radiale Randbereich des SiC-Volumeneinkristalls weist insbesondere die Umfangsrandfläche sowie an die Umfangsrandfläche angrenzende Teilbereiche der Bodenfläche und der Deckfläche auf.

Die erfindungsgemäße Vorrichtung und ihre Ausgestaltungen bieten im Wesentlichen die gleichen Vorteile, die bereits im Zusammenhang mit dem erfindungsgemäßen Verfahren und dessen Ausgestaltungen beschrieben worden sind.

Vorteilhafte Ausgestaltungen der erfindungsgemäßen Vorrichtung ergeben sich unter anderem aus den Merkmalen der von Anspruch 10 abhängigen Ansprüche.

Günstig ist eine Ausgestaltung, bei der die Kristallhalterung so ausgestaltet ist, dass der Wärmeaustausch des SiC-Volumeneinkristalls mit dem ihn umgebenden freien Raum mittels freier Wärmestrahlung an allen drei Begrenzungsflächen stattfindet.

Gemäß einer weiteren günstigen Ausgestaltung ist die Kristallhalterung so ausgestaltet ist, dass der Wärmeaustausch des SiC-Volumeneinkristalls mit dem ihn umgebenden freien Raum mittels freier Wärmestrahlung an einem Strahlungsflächenanteil einer Gesamtoberfläche des SiC-Volumeneinkristalls stattfindet, wobei sich die Gesamtoberfläche aus der Summe der drei Begrenzungsflächen zusammensetzt und der Strahlungsflächenanteil im Bereich von 63 % bis 83 %, insbesondere von 63 % bis 78% der Gesamtoberfläche liegt.

Gemäß einer weiteren günstigen Ausgestaltung ist die Kontaktierung des mindestens einen SiC-Volumeneinkristalls durch die Haltefläche so ausgestaltet, dass der radiale thermische Gradient in einem zentralen Bereich des SiC-Volumeneinkristalls Werte zwischen 0,1 K/cm und 0,3 K/cm, insbesondere zwischen 0,1 K/cm und 0,25 K/cm annimmt, wobei sich der zentrale Bereich des SiC-Volumeneinkristalls in radialer Richtung von der Kristallmittenlängsachse bis zu dem halben Kristalldurchmesser erstreckt.

Gemäß einer weiteren günstigen Ausgestaltung ist die Kontaktierung des mindestens einen SiC-Volumeneinkristalls durch die Haltefläche so ausgestaltet, dass der radiale thermische Gradient in einem Randbereich des SiC-Volumeneinkristalls, Werte zwischen 0,25 K/cm und 0,8 K/cm, insbesondere zwischen 0,25 K/cm und 0,7 K/cm annimmt, wobei sich der Randbereich des SiC-Volumeneinkristalls in radialer Richtung von dem halben Kristalldurchmesser bis zur Umfangsrandfläche erstreckt.

Gemäß einer weiteren günstigen Ausgestaltung ist die Nachbehandlungstemperatur ein Temperaturwert, der höher, insbesondere um bis zu 500 °C höher, vorzugsweise um bis zu 200 °C höher als eine Züchtungstemperatur ist, bei der der SiC-Volumeneinkristall vorher gezüchtet worden ist. Insbesondere ist die Nachbehandlungstemperatur größer als 1950 °C, bevorzugt größer als 2000 °C, vorzugsweise größer als 2200 °C, wobei ein oberer Grenzwert dieser Temperatur insbesondere bei 2500 °C, bevorzugt bei 2450 °C liegt.

Gemäß einer weiteren günstigen Ausgestaltung ist ein Innendurchmesser des Nachbehandlungstiegels größer als der Kristalldurchmesser, so dass bei in dem Nachbehandlungstiegel eingesetztem SiC-Volumeneinkristall zwischen der Umfangsrandfläche des SiC-Volumeneinkristalls und einer Innenwand des Nachbehandlungstiegels ein tangential vollständig umlaufender freier Ringspalt vorhanden ist. Dadurch findet an der Umfangsrandfläche des SiC-Volumeneinkristalls ein Wärmeaustausch mittels freier Wärmestrahlung mit dem sich dann auch in den freien Ringspalt erstreckenden freien Raum statt. Der Ringspalt hat eine Spaltbreite insbesondere im Bereich zwischen 5 mm und 20 mm, bevorzugt im Bereich zwischen 5 mm und 15 mm.

Gemäß einer weiteren günstigen Ausgestaltung ist die Kristallhalterung als ringförmige Kristallauflage ausgebildet. So kann sie den insbesondere im Bereich des Umfangrandes und der Bodenfläche im Wesentlichen zylinderförmigen SiC-Volumeneinkristall zum einen sehr gut tragen. Zum anderen kontaktiert die ringförmige Kristallauflage nur einen kleinen Teil der Begrenzungsflächen des SiC-Volumeneinkristalls, so dass ein großer Teil der Begrenzungsflächen für den Wärmeaustausch mittels freier Wärmestrahlung zur Verfügung steht.

Gemäß einer weiteren günstigen Ausgestaltung hat die Kristallauflage eine in axialer Richtung gemessene Dicke im Bereich zwischen 1 mm und 5 mm, insbesondere im Bereich zwischen 1 mm und 3 mm. Auch anhand der verwendeten Dicke der Kristallauflage lässt sich vorzugsweise die Wärmeleitung über die Kristallauflage steuern, womit dann auch der radiale thermische Gradient im zu tempernden SiC-Volumeneinkristall weiter angepasst und/oder eingestellt werden kann. Die Dicke der Kristallauflage ist insbesondere eines der Mittel zur Justage oder Feinjustage des Verhältnisses zwischen Wärmeleitung und Wärmestrahlung, also zwischen den beiden Wärmeaustauschmechanismen, mit denen der auf der Kristallauflage platzierte SiC-Volumeneinkristall während der thermischen Nachbehandlung Wärme mit seiner Umgebung, insbesondere mit anderen in seiner Umgebung befindlichen Gegenständen oder mit ihn umgebenden freier Raum, austauscht.

Gemäß einer weiteren günstigen Ausgestaltung weist ein Halterungsmaterial, aus dem die Kristallhalterung besteht oder das sie enthält, eine geringere thermische Leitfähigkeit auf als ein Tiegelmaterial, aus dem der Nachbehandlungstiegel besteht oder das er enthält. Auch anhand der thermischen Leitfähigkeit des Halterungsmaterials lässt sich vorzugsweise die Wärmeleitung über die Kristallauflage steuern, womit dann auch der radiale thermische Gradient im zu tempernden SiC-Volumeneinkristall weiter angepasst und/oder eingestellt werden kann. Die thermische Leitfähigkeit des Halterungsmaterials ist insbesondere ebenfalls eines der Mittel zur Justage oder Feinjustage des Verhältnisses zwischen Wärmeleitung und Wärmestrahlung von oder zu dem zu tempernden SiC-Volumeneinkristall. Das Halterungsmaterial kann insbesondere ein Graphit sein. Auch das Tiegelmaterial kann insbesondere ein Graphit sein.

Gemäß einer weiteren günstigen Ausgestaltung weist ein Halterungsmaterial, aus dem die Kristallhalterung besteht oder das sie enthält, eine höhere Porosität auf als ein Tiegelmaterial, aus dem der Nachbehandlungstiegel besteht oder das er enthält. Durch die höhere Porosität sinkt insbesondere der Anteil der Wärmeleitung, da weniger direkte Wärmebrücken, also weniger direkte Kontaktstellen, vorhanden sind. Auch anhand der Porosität des Halterungsmaterials lässt sich vorzugsweise die Wärmeleitung über die Kristallauflage steuern, womit dann auch der radiale thermische Gradient im zu tempernden SiC-Volumeneinkristall weiter angepasst und/oder eingestellt werden kann. Die Porosität des Halterungsmaterials ist insbesondere ebenfalls eines der Mittel zur Justage oder Feinjustage des Verhältnisses zwischen Wärmeleitung und Wärmestrahlung von oder zu dem zu tempernden SiC-Volumeneinkristall. Das Halterungsmaterial kann insbesondere ein poröser Graphit sein. Das Tiegelmaterial kann insbesondere ebenfalls ein Graphit sein. Graphit gibt es in unterschiedlichen Ausführungen. Ein Graphit des Halterungsmaterials ist vorzugsweise poröser als ein Graphit des Tiegelmaterials. Die Kristallhalterung kann insbesondere auch als ein zwei- oder mehrschichtiger Aufbau realisiert sein, der beispielsweise einen Grundkörper aus einem dichten ersten Halterungsmaterial, z.B. aus einem dichten Graphit, und eine den Grundkörper bedeckende Auflage aus einem verglichen mit dem ersten Halterungsmaterial poröseren zweiten Halterungsmaterial, z.B. aus einem porösen Graphit, enthält.

Gemäß einer weiteren günstigen Ausgestaltung ist der Aufnahmeraum dazu ausgelegt, den thermisch nachzubehandelnden mindestens einen SiC-Volumeneinkristall aufzunehmen, wobei die Kristalllänge höchstens 50 mm, insbesondere höchstens 45 mm beträgt. Vorzugsweise liegt die Kristalllänge zwischen 25 mm und 30 mm. Ein unterer Grenzwert für die Kristalllänge liegt insbesondere bei 15 mm, bevorzugt bei 25 mm und höchst bevorzugt bei 30 mm.

Gemäß einer weiteren günstigen Ausgestaltung ist der Aufnahmeraum dazu ausgelegt, den thermisch nachzubehandelnden mindestens einen SiC-Volumeneinkristall aufzunehmen, wobei der Kristalldurchmesser mindestens 150 mm, insbesondere mindestens 200 mm beträgt. Ein oberer Grenzwert für den Kristalldurchmesser liegt insbesondere bei 450 mm, bevorzugt bei 300 mm.

Gemäß einer weiteren günstigen Ausgestaltung ist der Aufnahmeraum dazu ausgelegt, den thermisch nachzubehandelnden mindestens einen SiC-Volumeneinkristall aufzunehmen, wobei ein Aspektverhältnis, das mittels Division der Kristalllänge durch den Kristalldurchmesser gebildet ist, im Bereich zwischen 0,05 und 0,35, insbesondere im Bereich zwischen 0,1 und 0,3 liegt.

Weitere Merkmale, Vorteile und Einzelheiten der Erfindung ergeben sich aus der nachfolgenden Beschreibung von Ausführungsbeispielen anhand der Zeichnung. Es zeigt:
- Fig. 1: ein erstes Ausführungsbeispiel einer Vorrichtung zur thermischen Nachbehandlung eines SiC-Volumeneinkristalls mit einer Kristallhalterung in einem Nachbehandlungstiegel,
- Fig. 2: einen vergrößerten Ausschnitt der Vorrichtung gemäß Fig. 1 mit dem zu tempernden und auf Kristallhalterung aufliegenden SiC-Volumeneinkristall,
- Fig. 3 bis 5: Ausführungsbeispiele von zu tempernden SiC-Volumeneinkristallen mit jeweils gleicher Kristalllänge aber verschiedenem Kristalldurchmesser, und
- Fig. 6 bis 8: weitere Ausführungsbeispiele von Vorrichtungen zur thermischen Nachbehandlung mit anderen Heizeinrichtungen.

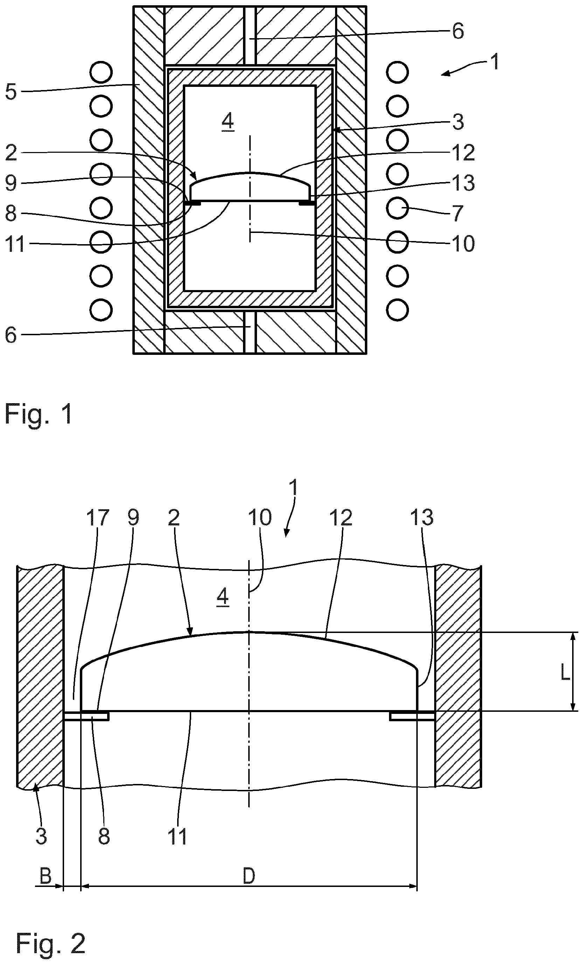

Einander entsprechende Teile sind in den Fig. 1 bis 8 mit denselben Bezugszeichen versehen. Auch Einzelheiten der im Folgenden näher erläuterten Ausführungsbeispiele können für sich genommen eine Erfindung darstellen oder Teil eines Erfindungsgegenstands sein.

In Fig. 1 und 2 ist ein Ausführungsbeispiel einer Vorrichtung 1 zur thermischen Nachbehandlung eines SiC-Volumeneinkristalls 2 gezeigt. Die Vorrichtung 1 kann auch als Temper-Vorrichtung bezeichnet werden.

Sie enthält einen Nachbehandlungstiegel 3, dessen Inneres einen Aufnahmeraum 4 für den thermisch nachzubehandelnden (= zu tempernden) SiC-Volumeneinkristall 2 bildet. Der Nachbehandlungstiegel 3 besteht aus einem Tiegelmaterial, das bei dem Ausführungsbeispiel ein dichter Graphit ist. Alternativ kann das Tiegelmaterial auch ein hochschmelzendes Metall wie z.B. Tantal (Ta), Wolfram (W) oder anderen Refraktärmetallen oder karbidisierten Metallen, beispielsweise Tantalcarbid (TaC) oder Wolframcarbid (WC), sein. Der Nachbehandlungstiegel 3 ist mit einer thermischen Isolation 5 umgeben, die beim gezeigten Ausführungsbeispiel aus Graphitfilz besteht. In der thermischen Isolation 5 sind an der Ober- und Unterseite zwei Öffnungen jeweils in Form eines Pyrometerkanals 6 vorhanden, um mittels nicht dargestellter Pyrometer die Temperatur am Nachbehandlungstiegel 3 messen zu können. Die thermische Isolation 5 ist von einer induktiven Heizeinrichtung in Form einer Heizspule 7 umgeben.

Im Aufnahmeraum 4 des Nachbehandlungstiegels 3 ist eine Kristallhalterung 8 angeordnet, die eine Haltefläche 9 hat, auf der der SiC-Volumeneinkristall 2 während der thermischen Nachbehandlung aufliegt. Die Kristallhalterung 8 ist als ringförmige Kristallauflage ausgestaltet und besteht bei dem gezeigten Ausführungsbeispiel aus einem Halterungsmaterial, das verglichen mit dem Tiegelmaterial eine höhere Porosität und eine niedrigere thermische Leitfähigkeit aufweist. Das Halterungsmaterial ist bei dem Ausführungsbeispiel ein poröser Graphit. Es gibt aber auch alternative Ausführungsbeispiele, bei denen das Halterungsmaterial eine gleiche oder zumindest ähnliche Porosität und thermische Leitfähigkeit wie das Tiegelmaterial hat, wobei diese beiden Materialeigenschaften dann nicht oder höchstens nur noch in sehr geringem Umfang als Parameter für die (Fein-)Einstellung des Verhältnisses von Wärmeleitung zu Wärmestrahlung in Frage kommen. Diese Einstellung erfolgt dann praktisch ausschließlich darüber, welchen Anteil die kontaktfreien Bereiche der Gesamtoberfläche an der Gesamtoberfläche des SiC-Volumeneinkristalls 2 haben (siehe nachfolgend).

Die gezeigte Vorrichtung 1 ist zur thermischen Nachbehandlung nur des einen SiC-Volumeneinkristalls 2 ausgelegt. Dies ist aber keine grundsätzliche Beschränkung. Es gibt auch andere Vorrichtungen, in denen zwei oder noch mehr SiC-Volumeneinkristalle gemeinsam getempert werden können.

Gemäß der in Fig. 2 gezeigten vergrößerten Darstellung des Ausschnitts der Vorrichtung 1, in dem sich der zu SiC-Volumeneinkristall 2 während seiner thermischen Nachbehandlung befindet, hat der zu tempernde SiC-Volumeneinkristall 2 eine im Wesentlichen zylindrische Grundform mit einer Kristallmittenlängsachse 10 sowie mit drei Begrenzungsflächen, nämlich einer ebenen kreisförmigen Bodenfläche 11, einer kappenförmigen Deckfläche 12 und einer zylindermantelförmigen Umfangsrandfläche 13. Die Kristallmittenlängsachse 10 verläuft in axialer Richtung, längs der der SiC-Volumeneinkristall 2 während seiner Züchtung aufgewachsen ist und längs der auch eine Kristalllänge L des SiC-Volumeneinkristalls 2 gemessen wird. In einer dazu senkrechten Richtung, nämlich in der radialen Richtung, wird ein Kristalldurchmesser D des SiC-Volumeneinkristalls 2 gemessen.

Im Laufe der Züchtung entstehen in der Kristallstruktur des aufwachsenden SiC-Volumeneinkristalls 2 mechanische Spannungen, die sich ungünstig auf die Geometrie und damit die Qualität der später aus dem SiC-Volumeneinkristall 2 hergestellten SiC-Substrate auswirken können. Deshalb sollen diese Spannungen durch eine thermische Nachbehandlung des SiC-Volumeneinkristalls 2 abgebaut werden.

Je größer der Kristalldurchmesser D des SiC-Volumeneinkristalls 2 ist, desto stärker beeinflusst der radiale Temperaturgradient (= thermische Gradient) die Eigenschaften des wachsenden SiC-Volumeneinkristalls 2 während der Züchtung. Zugleich wird der Einfluss des axialen Temperaturgradienten geringer.

Dies liegt auch daran, dass das zur Kristallzüchtung eingesetzte physikalische Gasphasenabscheidungsverfahren zwar die Herstellung von SiC-Volumeneinkristallen mit immer größeren Kristalldurchmessern D ermöglicht, bei der in axialer Richtung erzielbaren Kristalllänge L aber auf einige Zentimeter limitiert ist. Deshalb verändert sich das Verhältnis von Kristalllänge L zu Kristallmesser D, das hier als Aspektverhältnis bezeichnet wird, mit steigendem Kristalldurchmesser D. Es wird kleiner.

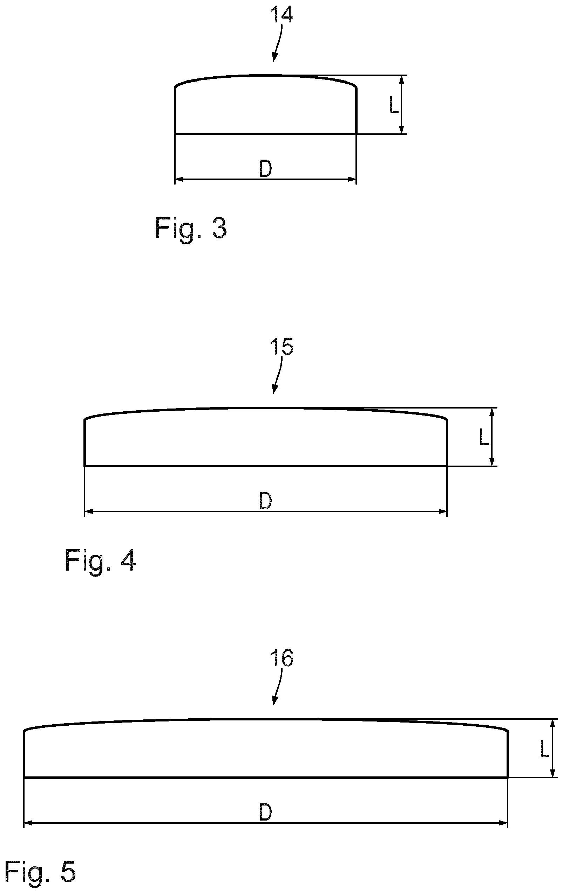

Die Darstellungen der Figuren 3 bis 5 veranschaulichen diesen Effekt. Gezeigt sind drei SiC-Volumeneinkristalle 14, 15 und 16 mit jeweils gleicher Kristalllänge L von 25 mm, aber unterschiedlichem Kristalldurchmesser D. So hat der SiC-Volumeneinkristall 14 gemäß Fig. 3 einen Kristalldurchmesser D von 76,2 mm und damit ein Aspektverhältnis L/D von 0,33. Der SiC-Volumeneinkristall 15 gemäß Fig. 4 hat einen Kristalldurchmesser D von 150 mm und damit ein Aspektverhältnis L/D von 0,17. Der SiC-Volumeneinkristall 16 gemäß Fig. 5 hat einen Kristalldurchmesser D von 200 mm und damit ein Aspektverhältnis L/D von 0,13.

Der steigende Einfluss der Verhältnisse in radialer Richtung wirkt sich auch auf die im aufwachsenden SiC-Volumeneinkristall 2 resultierenden Spannungen aus, die mit steigendem Kristalldurchmesser D immer stärker durch den radialen Temperaturgradienten bestimmt werden.

Es wurde erkannt, dass dieser Effekt auch bei der thermischen Nachbehandlung zu berücksichtigen ist. Um dabei einen möglichst vollständigen Spannungsabbau zu erzielen, werden im SiC-Volumeneinkristall 2 während des Nachbehandlungsprozesses besondere Temperaturverhältnisse in radialer Richtung vorgesehen. Vorteilhafterweise wird ein inhomogener Temperaturverlauf mit einem radialen Temperaturgradienten, der ausgehend von der Kristallmittenlängsachse zur Umfangsrandfläche kontinuierlich ansteigt, eingestellt.

Dieser spezielle inhomogene Temperaturverlauf innerhalb des zu tempernden SiC-Volumeneinkristalls 2 wird nicht alleine durch die äußere Heizeinrichtung der Vorrichtung 1 erzeugt. Die äußere Heizeinrichtung in Form der Heizspule 7 beeinflusst im Wesentlichen nur die Temperatur in der Tiegelwand des Nachbehandlungstiegels 3 unmittelbar. Innerhalb der Vorrichtung 1 stellt der Nachbehandlungstiegel 3 eine Art Heizung dar. Er transportiert die in ihn eingespeiste Wärme in den Aufnahmeraum 4 in seinem Inneren weiter. Um den Temperaturverlauf mit inhomogenem radialen Temperaturgradienten in dem SiC-Volumeneinkristall 2 einzustellen, sind bei der Vorrichtung 1 insbesondere weitere Maßnahmen zur Temperaturbeeinflussung vorgesehen.

Der Wärmetransportmechanismus, der die Wärme von der Tiegelwand ins Innere des Nachbehandlungstiegels 3 zu dem SiC-Volumeneinkristall 2 weiterleitet, hat ebenfalls einen Einfluss auf die Temperaturverteilung in dem SiC-Volumeneinkristall 2.

So wurde herausgefunden, dass ein Einbetten des SiC-Volumeneinkristalls 2 in SiC-Pulver eine Wärmeübertragung mittels Wärmestrahlung unterbindet. Stattdessen ist die Wärmeleitung maßgeblich für Wärmeübertragung. Weiterhin hat sich gezeigt, dass das SiC-Pulver einen eher isolierenden und homogenisierenden Einfluss auf das Temperaturprofil innerhalb des SiC-Volumeneinkristalls 2 hat. Ein inhomogener Temperaturverlauf mit einem radial ansteigenden Temperaturgradienten lässt sich so nicht einstellen.

Eine ähnliche Wirkung wie die vollständige Einbettung in SiC-Pulver stellt sich ein, wenn der SiC-Volumeneinkristall 2 mit seiner gesamten Bodenfläche 11 auf einer Auflagefläche, z.B. aus Graphit oder aus SiC-Pulver, aufliegt. Im Kontaktbereich zwischen der Bodenfläche 11 und der Auflagefläche erfolgt der Wärmetransport von und zu dem SiC-Volumeneinkristall 2 wieder mittels Wärmeleitung.

Eine weitere Erkenntnis liegt darin, dass für die Einstellung eines inhomogenen Temperaturverlaufs mit einem radial ansteigenden Temperaturgradienten im SiC-Volumeneinkristall 2 freie Wärmestrahlung der dominante Mechanismus für die Wärmeübertragung vom und zum SiC-Volumeneinkristall 2 sein sollte. Daneben gibt es aber insbesondere einen weiteren Mechanismus für die Wärmeübertragung, der auf der Wärmeleitung beruht. Über das Verhältnis des Anteils der Wärmeleitung an der Wärmeübertragung zu dem Anteil der Wärmestrahlung an der Wärmeübertragung lässt sich vorteilhafterweise der inhomogene Temperaturverlauf mit dem von innen nach außen radial ansteigenden Temperaturgradienten während der thermischen Nachbehandlung einstellen. Dementsprechend wird der SiC-Volumeneinkristall 2 durch die Kristallhalterung 8 so im Aufnahmeraum 4 gelagert bzw. gehalten, dass ein maßgeblicher bzw. überwiegender Anteil der Wärmeübertragung vom und zum SiC-Volumeneinkristall 2 mittels freier Wärmestrahlung stattfindet. Dazu ist die Kristallhalterung 8 vorzugsweise so ausgestaltet, dass der gehaltene SiC-Volumeneinkristall 2 am größten Teil seiner Gesamtoberfläche, die sich aus den drei Begrenzungsflächen, also der Bodenfläche 11, der Deckfläche 12 und der Umfangsrandfläche 13, zusammensetzt, keinen Kontakt zu einem anderen Gegenstand, wie z.B. zu der Innenwand des Nachbehandlungstiegels 3 oder zu der Haltefläche 9 der Kristallhalterung 8, hat. An diesen kontaktfreien Bereichen der Gesamtoberfläche des SiC-Volumeneinkristalls 2 erfolgt dann der Wärmeaustausch bzw. die Wärmeübertragung zwischen dem zu tempernden SiC-Volumeneinkristall 2 und dem an ihn angrenzenden freien Raum des Aufnahmeraums 4 mittels freier Wärmestrahlung. Diese kontaktfreien Bereiche bilden einen Strahlungsflächenanteil, der sich bezogen auf die Gesamtoberfläche des SiC-Volumeneinkristalls 2 insbesondere im Bereich zwischen 63 % und 83 % bewegt. An den übrigen Bereichen der Gesamtoberfläche des SiC-Volumeneinkristalls 2, deren Anteil an der Gesamtoberfläche sich dementsprechend insbesondere im Bereich zwischen 17 % und 37 % bewegt, kommt es dagegen zu einem Kontakt zu anderen Gegenständen oder Komponenten der Vorrichtung 1, insbesondere zur Kristallhalterung 8, so dass dort die Wärmeübertragung hauptsächlich mittels Wärmeleitung erfolgt.

Der Wärmeaustausch des SiC-Volumeneinkristalls 2 mit dem ihn umgebenden freien Raum mittels freier Wärmestrahlung findet vorzugsweise an mindestens zwei der drei Begrenzungsflächen statt, beim in Fig. 1 und 2 gezeigten Ausführungsbeispiel sogar an allen drei Begrenzungsflächen. Ein zentraler Teil der Bodenfläche 11 wird nicht durch die als ringförmige Kristallauflage ausgestaltete Kristallhalterung 8 kontaktiert. Die Bodenfläche 11 bleibt im Bereich der Ringöffnung der Kristallhalterung kontaktfrei, so dass dort ein Wärmeaustausch mit dem angrenzenden freien Raum mittels freier Wärmestrahlung erfolgt. Die Deckfläche 12 und die Umfangsrandfläche 13 sind komplett kontaktfrei und stehen damit komplett für einen Wärmeaustausch mittels freier Wärmestrahlung zur Verfügung.

Die Umfangsrandfläche 13 ist kontaktfrei, da ein Innendurchmesser des Nachbehandlungstiegels 3 größer als der Kristalldurchmesser D des SiC-Volumeneinkristalls 2 ist, so dass zwischen der Umfangsrandfläche 2 des eingesetzten SiC-Volumeneinkristalls 2 und der Innenwand des Nachbehandlungstiegels 3 ein tangential vollständig umlaufender freier Ringspalt 17 vorhanden ist. Dieser Ringspalt 17 hat eine Spaltbreite B von vorzugsweise 5 mm bis 20 mm (siehe Fig. 2).

Aufgrund dieses Wärmeaustausches zwischen dem SiC-Volumeneinkristall 2 und dem ihn umgebenden freien Raum mittels freier Wärmestrahlung stellt sich während der thermischen Nachbehandlung im SiC-Volumeneinkristall 2 ein vorteilhafter inhomogener Temperaturverlauf mit radial ansteigendem Temperaturgradienten ein, der zu dem erwünschten Abbau mechanischer Spannungen innerhalb des SiC-Volumeneinkristalls 2 führt.

Als optionale zusätzliche Maßnahmen zur weiteren Anpassung und Einstellung des radialen Temperaturgradienten kann die Dicke der als ringförmige Kristallauflage ausgestalteten Kristallhalterung 8 variiert und/oder für die Kristallhalterung 8 ein Halterungsmaterial mit einer entsprechend angepassten thermischen Wärmeleitfähigkeit oder Porosität genutzt werden. Insbesondere kann ein Halterungsmaterial mit einer niedrigen thermischen Wärmeleitfähigkeit und/oder mit hoher Porosität gewählt werden.

Abgesehen von den vorstehend beschriebenen Komponenten hat die Vorrichtung 1 weitere Bestandteile, die aus Übersichtlichkeitsgründen in Fig. 1 und 2 nicht mit dargestellt sind. So sind außerdem zumindest eine Evakuierungseinrichtung sowie eine Gaseinrichtung zur Zuführung eines kontrollierten Gasstroms eines Prozessgases sowie zur Aufrechterhaltung der Prozessgas-Atmosphäre während des Nachbehandlungsprozesses bei einem einstellbaren Prozessgasdruck vorhanden. Als Prozessgas wird Argon (Ar), Helium (He) oder Stickstoff (N) oder ein Gemisch aus diesen Gasen zugeführt.

Nachfolgend wird der thermische Nachbehandlungs-Prozess näher beschrieben.

Vor Beginn des eigentlichen Nachbehandlungs-Prozesses wird eine Evakuierung durchgeführt, um das Erreichen einer kontrollierten Atmosphäre zu gewährleisten und um Verunreinigungen zu minimieren. Vor dem Aufheizen wird dann ein Prozessgasdruck im Bereich von 800 mbar bis 1200 mbar, bevorzugt von 800 mbar bis 1000 mbar eingestellt, um das oberflächliche Abdampfen von SiC-Material von dem zu tempernden SiC-Volumeneinkristall 2 so gering wie möglich zu halten.

Der Nachbehandlungstiegel 3 wird dann mit dem darin platzierten SiC-Volumeneinkristall 2 auf die gewünschte Prozesstemperatur aufgeheizt, wobei nach Erreichen eines Temperaturbereichs von 900 °C bis 1500 °C, bevorzugt von 1000 °C bis 1200 °C, der weitere Temperaturanstieg bis zur eigentlichen Nachbehandlungstemperatur mit einer Temperaturrampe von 1 °C/h bis 5 °C/h durchgeführt wird, um die Bildung zusätzlicher Spannungen zu vermeiden. Die eigentlichen Nachbehandlungstemperaturen liegen um bis 500 °C, bevorzugt um bis 200 °C, oberhalb der Züchtungstemperatur, bei der die Züchtung des SiC-Volumeneinkristalls 2 erfolgt ist. Die Nachbehandlungstemperatur bewegt sich damit in einem Bereich von 1950 °C bis 2450 °C.

Nach Beginn der eigentlichen thermischen Nachbehandlung werden die Prozessbedingungen Druck, Atmosphärenzusammensetzung und Temperatur für eine Prozesszeitspanne, die zwischen 5 h und 72 h, bevorzugt zwischen 15 h bis 50 h, dauert, möglichst konstant gehalten. Geringfügige Temperaturschwankungen sind kleiner als 10 °C, bevorzugt kleiner als 2 °C. Dadurch wird einerseits ausreichend Zeit für den Abbau mechanischer Spannungen in der Kristallstruktur des SiC-Volumeneinkristalls zur Verfügung gestellt. Andererseits wird der Spannungsabbau nicht durch Fluktuationen der Prozessparameter behindert.

Nach Ablauf der Prozesszeit wird der SiC-Volumeneinkristall 2 langsam mit einer Temperaturrampe von 0,5 °C/h bis 3 °C/h, bevorzugt von 0,5 °C/h bis 2 °C/h bis auf einen Temperaturbereich von 900 °C bis 1500 °C, bevorzugt von 1000 °C bis 1200 °C, abgekühlt, um die Neubildung mechanischer Spannungen aufgrund von Temperatur-Inhomogenitäten, die durch Wärmtransportmechanismen hervorgerufenen werden können, zu vermeiden. Nach dem endgültigen Abkühlen des Nachbehandlungstiegels 3 und des getemperten SiC-Volumeneinkristall 2 ungefähr auf Raumtemperatur wird der Nachbehandlungstiegel 3 mit Umgebungsatmosphäre geflutet und der SiC-Volumeneinkristall 2 zur Weiterverarbeitung entnommen.

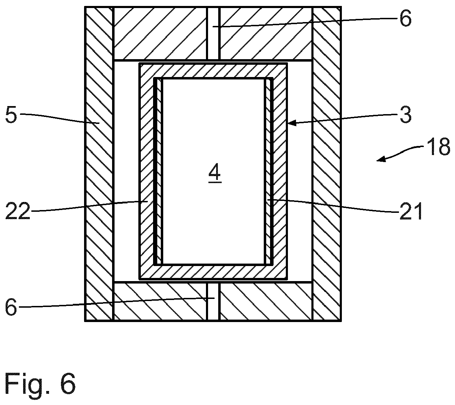

Die Vorrichtung 1 gemäß Fig. 1 und 2 hat eine induktive Heizeinrichtung, durch die die globale Temperaturverteilung innerhalb des Nachbehandlungstiegels 3 eingestellt werden kann. Die Heizeinrichtung muss aber nicht zwingend induktiv ausgeführt sein. In den Figuren 6 bis 8 sind alternative Temper-Vorrichtungen 18, 19 und 20 zur thermischen Nachbehandlung des SiC-Volumeneinkristalls 2, die anstelle der Heizspule 7 mit Widerstandsheizungen ausgestattet sind. Anhand dieser Widerstandsheizungen lässt sich die globale Temperaturverteilung innerhalb des Nachbehandlungstiegels 3 ebenso einstellen wie mit der Induktionsheizung der Vorrichtung 1. Mit beiden Heizkonzepten kann aber immer nur die Temperatur des Nachbehandlungstiegels 3 selbst eingestellt werden. Die vorstehend anhand von Vorrichtung 1 beschriebenen zusätzlichen Temperaturbeeinflussungsmaßnahmen kommen vorteilhafterweise auch bei den Temper-Vorrichtungen 18, 19, 20 zum Einsatz, obwohl sie wie auch einige andere Komponenten der Temper-Vorrichtungen 18, 19, 20 nicht in Fig. 6 bis 8 mit dargestellt sind.

Bei der Temper-Vorrichtung 18 gemäß Fig. 6 ist ein zylindermantelförmiges Widerstandsheizelement 21 innerhalb des Nachbehandlungstiegels 3 benachbart zu oder anliegend an der tangential umlaufenden zylindrischen Tiegelseitenwand 22 angeordnet.

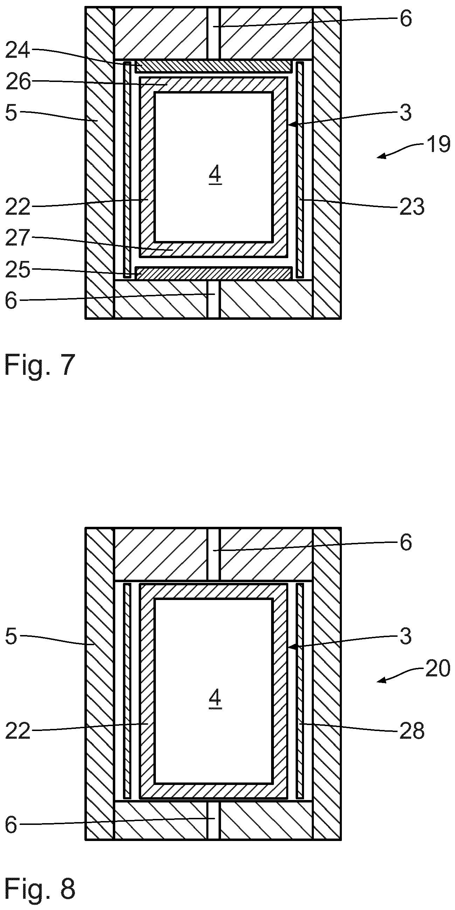

Bei der Temper-Vorrichtung 19 gemäß Fig. 7 sind ein zylindermantelförmiges Widerstandsheizelement 23 und zwei kreisförmige Widerstandsheizelemente 24 und 25 außerhalb des Nachbehandlungstiegels 3, aber innerhalb der Isolation 5 angeordnet. Das Widerstandsheizelement 23 umgibt die zylindrische Tiegelseitenwand 22. Jedes der Widerstandsheizelemente 24 und 25 bedeckt an der Oberseite bzw. Unterseite des Nachbehandlungstiegels 3 die jeweilige axiale Tiegelstirnwand 26 bzw. 27.

Bei der Temper-Vorrichtung 20 gemäß Fig. 8 umgibt ein zylindermantelförmiges Widerstandsheizelement 28 außerhalb des Nachbehandlungstiegels 3 und innerhalb der Isolation 5 die zylindrische Tiegelseitenwand 22. Das Widerstandsheizelement 28 ist vergleichbar zu dem Widerstandsheizelement 23 der Temper-Vorrichtung 19. Im Unterschied zu der Temper-Vorrichtung 19 sind bei der Temper-Vorrichtung 20 an den beiden axialen Stirnseiten des Nachbehandlungstiegels 3 keine Widerstandsheizelemente vorhanden.

Die Vorrichtungen 1, 18, 19 und 20 haben jeweils rotationssymmetrisch ausgeführte Heizeinrichtungen. Hierbei handelt es sich um Ausführungsbeispiele. Es sind auch andere, insbesondere nicht rotationssymmetrische Aufbauten und alternative Anordnungen der Heizeinrichtungen, bzw. Kombinationen aus unterschiedlichen Heizeinrichtungen möglich.

Insgesamt ermöglichen alle Vorrichtungen 1, 18, 19 und 20 eine sehr vorteilhafte thermische Nachbehandlung, bei der innerhalb des zu tempernden SiC-Volumeneinkristalls 2 ein inhomogener Temperaturverlauf mit einem radial ansteigenden Temperaturgradienten entsprechend dem Spannungshaushalt im Innern des SiC-Volumeneinkristalls 2 eingestellt wird. Dies führt zu einem sehr guten Abbau der vorhandenen mechanischen Spannungen. Aus einem so thermisch nachbehandelten SiC-Volumeneinkristall 2 können qualitativ hochwertige SiC-Substrate mit sehr geringer Verbiegung und Wölbung hergestellt werden.

## Patentansprüche

1. Verfahren zur thermischen Nachbehandlung mindestens eines SiC-Volumeneinkristalls (2), der eine im Wesentlichen zylindrische Grundform mit einer in einer axialen Richtung gemessenen Kristalllänge, mit einem in einer radialen Richtung gemessenen Kristalldurchmesser, mit einer in der axialen Richtung verlaufenden Kristallmittenlängsachse (10) sowie mit drei Begrenzungsflächen, nämlich einer Bodenfläche (11), einer Deckfläche (12) und einer Umfangsrandfläche (13), aufweist, wobei
a) der SiC-Volumeneinkristall (2) zur Reduzierung von im SiC-Volumeneinkristall (2) nach Abschluss der vorausgegangenen Züchtung vorhandener mechanischer Spannungen auf eine Nachbehandlungstemperatur gebracht wird, wobei
b) im SiC-Volumeneinkristall (2) ein inhomogener Temperaturverlauf mit einem radialen thermischen Gradienten, der ausgehend von der Kristallmittenlängsachse (10) zur Umfangsrandfläche (13) kontinuierlich ansteigt, eingestellt wird, und
c) ein Wärmeaustausch des SiC-Volumeneinkristalls (2) mit einem ihn umgebenden freien Raum (4) mittels freier Wärmestrahlung an mindestens zwei der drei Begrenzungsflächen (11, 12, 13) stattfindet.

2. Verfahren nach Anspruch 1, **dadurch gekennzeichnet, dass** der Wärmeaustausch des SiC-Volumeneinkristalls (2) mit dem ihn umgebenden freien Raum (4) mittels freier Wärmestrahlung an allen drei Begrenzungsflächen (11, 12, 13) stattfindet.

3. Verfahren nach Anspruch 1 oder 2, **dadurch gekennzeichnet, dass** der Wärmeaustausch des SiC-Volumeneinkristalls (2) mit dem ihn umgebenden freien Raum (4) mittels freier Wärmestrahlung an einem Strahlungsflächenanteil einer Gesamtoberfläche des SiC-Volumeneinkristalls (2) stattfindet, wobei sich die Gesamtoberfläche aus der Summe der drei Begrenzungsflächen (11, 12, 13) zusammensetzt und der Strahlungsflächenanteil im Bereich von 63 % bis 83 % der Gesamtoberfläche liegt.

4. Verfahren nach einem der vorhergehenden Ansprüche, **dadurch gekennzeichnet, dass** der radiale thermische Gradient so eingestellt wird, dass er in einem zentralen Bereich des SiC-Volumeneinkristalls (2), der sich in radialer Richtung von der Kristallmittenlängsachse (10) bis zu dem halben Kristalldurchmesser erstreckt, Werte zwischen 0,1 K/cm und 0,3 K/cm annimmt.

5. Verfahren nach einem der vorhergehenden Ansprüche, **dadurch gekennzeichnet, dass** der radiale thermische Gradient so eingestellt wird, dass er in einem Randbereich des SiC-Volumeneinkristalls (2), der sich in radialer Richtung von dem halben Kristalldurchmesser bis zur Umfangsrandfläche erstreckt, Werte zwischen 0,25 K/cm und 0,8 K/cm annimmt.

6. Verfahren nach einem der vorhergehenden Ansprüche, **dadurch gekennzeichnet, dass** um den SiC-Volumeneinkristall (2) eine Gasatmosphäre eingestellt wird, wozu mindestens ein siliziumfreies Prozessgas, welches insbesondere ein Gas aus der Gruppe von Argon, Helium, einem anderen Edelgas und Stickstoff oder ein Gasgemisch aus dieser Gruppe ist, zugeführt wird.

7. Verfahren nach einem der vorhergehenden Ansprüche, **dadurch gekennzeichnet, dass** die Kristalllänge höchstens 50 mm beträgt.

8. Verfahren nach einem der vorhergehenden Ansprüche, **dadurch gekennzeichnet, dass** der Kristalldurchmesser mindestens 150 mm beträgt.

9. Verfahren nach einem der vorhergehenden Ansprüche, **dadurch gekennzeichnet, dass** ein Aspektverhältnis, das mittels Division der Kristalllänge durch den Kristalldurchmesser gebildet ist, im Bereich zwischen 0,05 und 0,35 liegt.

10. Vorrichtung zur thermischen Nachbehandlung mindestens eines SiC-Volumeneinkristalls (2), der eine im Wesentlichen zylindrische Grundform mit einer in einer axialen Richtung gemessenen Kristalllänge, mit einem in einer radialen Richtung gemessenen Kristalldurchmesser, mit einer in der axialen Richtung verlaufenden Kristallmittenlängsachse (10) sowie mit drei Begrenzungsflächen, nämlich einer Bodenfläche (11), einer Deckfläche (12) und einer Umfangsrandfläche (13), aufweist, wobei die Vorrichtung aufweist
a) einen thermischen Nachbehandlungstiegel (3) mit einem Aufnahmeraum (4) für den thermisch nachzubehandelnden mindestens einen SiC-Volumeneinkristall (2),
b) eine Heizeinrichtung (7; 21; 23, 24,25; 28) zur Erhitzung des Nachbehandlungstiegels (3) sowie des darin zur Reduzierung von im SiC-Volumeneinkristall (2) nach Abschluss der vorausgegangenen Züchtung vorhandener mechanischer Spannungen zu platzierenden SiC-Volumeneinkristalls (2) auf eine Nachbehandlungstemperatur,
c) eine im Nachbehandlungstiegel (2) angeordnete Kristallhalterung (8) mit einer Haltefläche (9) zur Kontaktierung und Halterung des thermisch nachzubehandelnden mindestens einen SiC-Volumeneinkristalls (2),
d) wobei die Haltefläche (9) den nachzubehandelnden mindestens einen SiC-Volumeneinkristall (2) nur in einem radialen Randbereich des SiC-Volumeneinkristalls (2) kontaktiert, so dass
d1) sich im nachzubehandelnden mindestens einen SiC-Volumeneinkristall (2) ein inhomogener Temperaturverlauf mit einem radialen thermischen Gradienten, der ausgehend von der Kristallmittenlängsachse (10) zur Umfangsrandfläche (13) kontinuierlich ansteigt, einstellt, und
d2) ein Wärmeaustausch des nachzubehandelnden mindestens einen SiC-Volumeneinkristalls (2) mit einem ihn umgebenden freien Raum mittels freier Wärmestrahlung an mindestens zwei der drei Begrenzungsflächen (11, 12, 13) stattfindet, wobei der freie Raum ein Bestandteil des Aufnahmeraums (4) ist.

11. Vorrichtung nach Anspruch 10, **dadurch gekennzeichnet, dass** ein Innendurchmesser des Nachbehandlungstiegels (3) größer ist als der Kristalldurchmesser, so dass bei in dem Nachbehandlungstiegel (3) eingesetztem SiC-Volumeneinkristall (2) zwischen der Umfangsrandfläche (13) des SiC-Volumeneinkristalls (2) und einer Innenwand des Nachbehandlungstiegels (3) ein tangential vollständig umlaufender freier Ringspalt (17) vorhanden ist.

12. Vorrichtung nach Anspruch 10 oder 11, **dadurch gekennzeichnet, dass** die Kristallhalterung (8) als ringförmige Kristallauflage ausgebildet ist.

13. Vorrichtung nach Anspruch 12, **dadurch gekennzeichnet, dass** die Kristallauflage (8) eine in axialer Richtung gemessene Dicke im Bereich zwischen 1 mm und 5 mm hat.

14. Vorrichtung nach einem der Ansprüche 10 bis 13, **dadurch gekennzeichnet, dass** ein Halterungsmaterial, aus dem die Kristallhalterung (8) besteht oder das sie enthält, eine geringere thermische Leitfähigkeit aufweist als ein Tiegelmaterial, aus dem der Nachbehandlungstiegel (3) besteht oder das er enthält.

15. Vorrichtung nach einem der Ansprüche 10 bis 14, **dadurch gekennzeichnet, dass** ein Halterungsmaterial, aus dem die Kristallhalterung (8) besteht oder das sie enthält, eine höhere Porosität aufweist als ein Tiegelmaterial, aus dem der Nachbehandlungstiegel (3) besteht oder das er enthält.
